# EUROPÄISCHE PATENTSCHRIFT

(11) **EP 3 736 596 B1**
(45) Veröffentlichungstag und Bekanntmachung des Hinweises auf die Patenterteilung: **25.06.2025**
(21) Anmeldenummer: 19172744.5
(22) Anmeldetag: 06.05.2019
(51) Int. Cl.: G01S 5/02, G01S 19/48, G01S 5/14

(54) **ZUSATZMODUL FÜR EIN GERÄT, SERVEREINRICHTUNG, LOKALISIERUNGSVERFAHREN, COMPUTERPROGRAMM UND ENTSPRECHENDES SPEICHERMEDIUM**
ADD-ON MODULE FOR A DEVICE, SERVER DEVICE, POSITIONING METHOD, COMPUTER PROGRAM AND CORRESPONDING STORAGE MEDIUM
MODULE SUPPLÉMENTAIRE POUR UN APPAREIL, DISPOSITIF SERVEUR, PROCÉDURE DE LOCALISATION, PROGRAMME INFORMATIQUE ET SUPPORT D'ENREGISTREMENT CORRESPONDANT

(43) Veröffentlichungstag der Anmeldung: 11.11.2020
(73) Patentinhaber: Siemens Healthineers AG, 91301 Forchheim (DE)
(72) Erfinder: Nguyen, Quoc-Viet, 91054 Erlangen (DE)
(74) Vertreter: Siemens Healthineers Patent Attorneys

(56) Entgegenhaltungen:
- CN-A- 107 529 222
- DE-A1- 102005 007 309
- DE-A1- 102013 013 156
- DE-A1- 102015 117 280
- US-A1- 2011 117 924
- IBRAHIM MAI ET AL: "CNN based Indoor Localization using RSS Time-Series", 2018 IEEE SYMPOSIUM ON COMPUTERS AND COMMUNICATIONS (ISCC), IEEE, 25 June 2018 (2018-06-25), pages 1044 - 1049, XP033448566, DOI: 10.1109/ISCC.2018.8538530

## Beschreibung

Die vorliegende Erfindung betrifft ein Zusatzmodul für ein, insbesondere mobiles, Gerät, eine Servereinrichtung zum Kommunizieren mit dem Zusatzmodul beziehungsweise mit dem mobilen Gerät, ein korrespondierendes Lokalisierungsverfahren zum Lokalisieren des Zusatzmoduls beziehungsweise des mobilen Geräts, ein entsprechendes Computerprogramm oder Computerprogrammprodukt, das das Lokalisierungsverfahren implementiert, und ein entsprechendes computerlesbares Speichermedium.

Lokalisierung, also Ortung oder Ortsbestimmung, von Geräten, Material und Personen ist in einer großen Vielfalt von Anwendungsbereichen eine nützliche Funktionalität. Dabei werden bisher unterschiedliche Methoden angewendet. Bekannt sind beispielsweise satellitengestützten Positionsbestimmungssysteme (GPS, GLONASS, etc.) oder eine aktive Ortung mittels Radar oder durch Kommunikation zwischen einem Positionsbestimmungssystem und einem zu ortenden Gerät, beispielsweise durch Auslesen von RFID-Tags passierender Geräte an einem Kontrollpunkt. Diese Lösungen können allerdings den Nachteil haben, dass sie abhängig von jeweils lokalen Signalempfangsbedingungen, beispielsweise innerhalb von Gebäuden, nicht zuverlässig funktionieren und/oder eine einheitliche elektronische Infrastruktur auf Seiten des Positionsbestimmungssystems und aller zu ortenden Geräte, also beispielsweise die Verwendung vorgegebener Kommunikationsstandards, -frequenzen und -protokolle, voraussetzen. Dadurch kann eine Flexibilität der jeweiligen Lösung eingeschränkt sein. Ein weiterer Nachteil herkömmlicher Lösungen kann darin gesehen werden, dass durch die verwendeten Signale sensible Geräte oder Anlagen beeinträchtigt oder gestört werden könnten oder die Lokalisierungsverfahren nicht in entsprechend emissionssensiblen Bereichen angewendet werden können.

Dokument DE 10 2005 007 309 A1 beschreibt ein Mobilgerät zur Standortbestimmung, das zur Bestimmung seines momentanen Standorts an diesem Standort vorherrschende Umweltdaten aufnimmt und an eine Datenbank überträgt. Anschließend wird in der Datenbank eine Suche durchführt, bei der in Abhängigkeit von den Umweltdaten zugehörige Ortsinformationen ermittelt werden. Diese Ortsinformationen werden danach von der Datenbank an das Mobilgerät übertragen. Die Umweltdaten können von terrestrischen Quellen hervorgerufene elektromagnetische Wellen verschiedener Frequenzbereiche beinhalten. Beispielsweise können die Umweltdaten Radiosignale oder WLAN-Signale beinhalten. Es wird die Möglichkeit erwähnt, Sender dadurch vorzusehen, dass innerhalb eines Gebäudes eine Hochfrequenzleitung verlegt wird, welche in verschiedenen Räumen, eine Stichleitung oder dergleichen zur lokalen Auskopplung eines Signals für das Mobilgerät aufweist.

Dokument DE 10 2013 013156A1 beschreibt ein Verfahren zur Fußgängernavigation in einem Gebäude mit Hilfe eines mobilen Kommunikationsgerät und einer Vielzahl von in dem Gebäude angeordneten Sendern. Dazu wird eine Applikation in das elektronische Gerät geladen, wobei in einer Datenbank der Applikation der Grundriss des Gebäudes, die durch Koordinaten bezeichneten Orte der einzelnen Sender und die Kennungen der einzelnen Sender gespeichert sind. Durch das Kommunikationsgerät wird nach vorhandenen Sendern gesucht, die Kennungen und Signalstärken der empfangbaren Sender werden erfasst, die Kommunikation mit den empfangbaren Sendern wird abgebrochen und die aktuelle Position des Kommunikationsgeräts wird durch Vergleich der Kennungen der erfassten Sender mit den in der Datenbank der gespeicherten Koordinaten der Sender. Die aktuelle Position wird durch Auswertung der Signalstärken der erfassten Sender präzisiert.

Dokument DE 10 2015 117 280 A1 betrifft eine Ortungsvorrichtung zur Ortung eines mobilen Objektes, wobei eine Erfassungseinrichtung zur Erfassung freier elektromagnetischer Feldstärken vorgesehen ist und ein Auswertungsmodul anhand der erfassten freien elektromagnetischen Feldstärken Ortungsdaten für das mobile Objekt ermittelt. Dabei soll durch die Auswertung freier Feldstärken ausdrücklich auf die Verwendung dedizierter Referenzquellen verzichtet werden. Die freien elektromagnetischen Feldstärken sind dabei solche, die durch natürliche elektromagnetische Felder, zum Beispiel durch die Sonne verursacht, oder künstliche elektromagnetische Felder, beispielsweise durch Stromleitungen, Umspannwerke, Satelliten und so weiter erzeugt werden.

Dokument US 2011/0117924 Al beschreibt ein Ortungsverfahren, bei dem Mobilstation einen Signalstärkeindikator RSSI bestimmt und/oder eine Signallaufzeitmessung durchführt. Basierend auf einem Vergleich mit auf einer Datenbank gespeicherten Charakteristika wird eine satellitengestützte Positionsbestimmung, die auf einer Koppelnavigation beruht, verbessert.

Die Veröffentlichung "CNN based Indoor Localization using RSS Time-Series", M. Ibrahim et al., 2018 IEEE Symposium on Computers and Communications (ISCC), 25. Juni 2018, Seiten 1044-1049, beschreibt ein Indoor-Ortungsverfahren, bei dem Zeitreihen von Wifi-Signalstärken RSS aufgezeichnet werden und als Eingangsdaten einem trainierten künstlichen neuronalen Netzwert zur Verfügung gestellt werden. Das Netzwerk prädiziert basierend auf der Zeitserie der Signalstärken eine Position eines mobilen Knotens. Die RSS Werte werden dabei an einen Server übertragen, um die Vorhersage mittels des neuronalen Netzwerks zu treffen.

Aufgabe der vorliegenden Erfindung ist es, eine Lokalisierung von Geräten in Gebäuden und sensiblen Bereichen zu ermöglichen. Diese Aufgabe wird erfindungsgemäß durch die Gegenstände der unabhängigen Patentansprüche gelöst. Vorteilhafte Ausgestaltungen und Weiterbildungen der vorliegenden Erfindung sind in den abhängigen Patentansprüchen, in der Beschreibung und in den Figuren angegeben.

Ein erfindungsgemäßes Zusatzmodul ist ausgebildet zum Integrieren in ein bestehendes, insbesondere mobiles, Gerät, um dieses Gerät mit einer Lokalisierungsfunktionalität auszustatten. Das Zusatzmodul ermöglicht also - gegebenenfalls in Zusammenspiel mit dem jeweiligen Gerät - eine Ortsbestimmung des Zusatzmoduls beziehungsweise des mit dem Zusatzmodul ausgestatteten Geräts.

Ein Integrieren in diesem Sinne kann etwa ein Verbinden des Zusatzmoduls mit dem mobilen Gerät über einen Anschluss, eine Schnittstelle, eine elektrische Verbindung oder eine Datenverbindung bedeuten oder umfassen. Das Zusatzmodul kann dann über die Anschlussschnittstelle Daten oder Signale mit dem jeweiligen Gerät austauschen oder auf Ressourcen des Geräts zugreifen. Ebenso kann das Zusatzmodul als autarke Einheit ausgebildet sein, wobei das Integrieren des Zusatzmoduls in das jeweilige Gerät dann beispielsweise lediglich ein mechanisches Verbinden des Zusatzmoduls mit dem mobilen Gerät bedeuten kann.

Das Gerät im Sinne der vorliegenden Erfindung kann also ein elektrisches oder elektronisches Gerät sein, das über eigene elektrische und/oder elektronische Einrichtungen verfügt. Ebenso kann das Gerät im Sinne der vorliegenden Erfindung aber ein nicht-elektronisches Gerät, ein Werkzeug, ein Transportgut, ein Bauteil, ein Transportwagen, eine Patientenliege, ein - insbesondere von einer Person getragenes - Kleidungsstück und/oder dergleichen mehr sein.

Das erfindungsgemäße Zusatzmodul weist eine Messeinrichtung und eine Lokalisierungseinrichtung auf. Die Messeinrichtung ist dabei dazu eingerichtet, mittels einer Sensorik eine von einer jeweiligen umgebenden Infrastruktur verursachte lokale elektromagnetische Feldverteilung passiv ohne Datenaustausch mit dieser Infrastruktur zu messen. Das Messen der Feldverteilung kann beispielsweise ein Messen oder Bestimmen einer lokalen Feldstärke, eines Feldgradienten, eines Energie- und/oder Frequenzspektrums lokaler elektromagnetischer Felder oder Strahlung, deren Polarisation und/oder dergleichen mehr bedeuten oder umfassen. Die Lokalisierungseinrichtung ist dabei dazu eingerichtet, automatisch eine jeweils aktuelle räumliche Position des Zusatzmoduls zu bestimmen durch Abgleichen der gemessenen Feldverteilung mit einer vorgegebenen Karte, die eine ortsaufgelöste Referenzfeldverteilung und Positionen der feldverursachenden Infrastruktur angibt.

Weiter kann die Lokalisierungseinrichtung dazu eingerichtet sein, zum Ermöglichen eines Nachverfolgens (englisch: Tracking) des Zusatzmoduls beziehungsweise des jeweiligen damit ausgestatteten Geräts die gemessene Feldverteilung und/oder die bestimmte Position über eine kabellose Datenverbindung an eine externe Servereinrichtung, also beispielsweise einen Server, einen Cloudserver, ein Rechenzentrum oder dergleichen, zu senden. In ersterem Fall kann die Servereinrichtung die gemessene Feldverteilung dann zum Lokalisieren des Zusatzmoduls beziehungsweise des jeweiligen mobilen Geräts auswerten, beispielsweise durch Abgleichen der gemessenen Feldverteilung mit der vorgegebenen Karte.

Die vorgegebene Karte ist als Gebäudeplan ausgestaltet, in dem die Positionen der feldverursachenden Infrastruktur eingetragen sind. Zusätzlich ist darin die Referenzfeldverteilung, beispielsweise als Heatmap oder entsprechend einer topologischen Karte, eingetragen sein, wobei beispielsweise Linien oder einheitlich markierte Bereiche gleiche Feldverteilungen oder gleiche Werte von Parametern der Feldverteilung angeben können.

Die Referenzfeldverteilung kann beispielsweise durch eine vorbereitende Messung bestimmt und dann vorgegeben, also bereitgestellt werden, etwa an einen Hersteller des Zusatzmoduls oder einen Betreiber der Servereinrichtung. Besonders vorteilhaft kann die Referenzfeldverteilung von einem jeweiligen Nutzer oder Anwender des Zusatzmoduls auf dieses aufgespielt werden. Dadurch kann das erfindungsgemäße Zusatzmodul vorteilhaft besonders einfach und flexibel an unterschiedliche Einsatzbereiche, beispielsweise unterschiedliche Gebäudekomplexe und/oder an eine Veränderung der jeweiligen feldverursachenden Infrastruktur angepasst werden. Die feldverursachende Infrastruktur kann insbesondere ortsfeste Geräte oder Einrichtungen umfassen, welche elektromagnetische Felder oder Strahlung aussenden. Dies können beispielsweise Router, Repeater oder Zugangspunkte, (Access points) einer WLAN-Netzwerkinfrastruktur, mit Funkeinrichtungen ausgestattete elektronische Geräte, wie etwa, insbesondere ortsfest installierte, Fernseher, Getränkeautomaten, Kaffeemaschinen, Rauchmelder, Produktionsmaschinen, Fertigungseinrichtungen, Steuer- oder Überwachungssysteme, medizinische Geräte und/oder dergleichen mehr sein.

Derartige Geräte und Einrichtungen, also die feldverursachenden Infrastruktur, verursacht eine individuelle elektromagnetische Feldverteilung abhängig von den relativen Positionen sowie den Arten oder Typen der Geräte und Einrichtungen, welche die feldverursachende Infrastruktur bilden. Die vorliegende Erfindung schlägt also insbesondere eine auf Seiten des zu ortenden Geräts passive Ortsbestimmung anhand der gemessenen Feldverteilung vor. Das bedeutet, dass das zu ortende Gerät nicht notwendigerweise selbst aktiv senden oder etwa mit einer externen Positionsbestimmungseinrichtung kommunizieren muss. Damit bietet sich also der Vorteil, dass keine Kommunikation, also keine Signal- oder Datenübermittlung zwischen der feldverursachenden Infrastruktur und dem jeweils zu lokalisierenden Zusatzmodul oder Gerät stattfinden muss und ebenso keine dedizierte Infrastruktur zur Positionsbestimmung des Geräts installiert werden muss. Das Zusatzmodul beziehungsweise das jeweilige mobile Gerät muss also vorteilhaft auch nicht auf die jeweilige feldverursachende Infrastruktur angepasst oder abgestimmt werden oder mit der Infrastruktur registriert sein.

Zudem kann die Lokalisierung oder Nachverfolgung auch in emissionssensiblen, also signal- oder funksensiblen, Bereichen angewendet werden, da das Zusatzmodul beziehungsweise das jeweilige mobile Gerät selbst keinerlei Funksignale oder Strahlung oder dergleichen für die Lokalisierung aussenden muss. Derartige sensible Bereiche können beispielsweise eine Intensivstation oder Radiologie-Abteilung in einem Krankenhaus sein, wo derzeit oftmals die Weisung gilt, dass mobile elektronische Geräte in einen passiven Betriebsmodus (Flugzeugmodus) geschaltet oder ausgeschaltet werden müssen.

Da aber vorliegend dennoch aktive Feldimmissionen - nämlich die von der vorhandenen feldverursachenden Infrastruktur ausgesendete oder erzeugte elektromagnetische Feldverteilung - für die Lokalisierung genutzt werden, können mit der vorliegenden Erfindung die Vorteile einer aktiven und einer passiven Ortsbestimmung genutzt und dabei gleichzeitig deren jeweilige Nachteile vermieden werden. So ist beispielsweise mit der vorliegenden Erfindung im Gegensatz zu herkömmlichen Lösungsansätzen typischerweise keine direkte Sichtverbindung zwischen der Infrastruktur und dem Zusatzmodul beziehungsweise dem jeweiligen mobilen Gerät oder zwischen diesem und einem Positionsmarker oder einer für ein optisches Tracking vorgesehenen Kamera oder dergleichen notwendig.

Da die Feldverteilung durch einen regulären, von der Lokalisierungsfunktionalität unabhängigen Betrieb der Infrastruktur erzeugt wird und diese Infrastruktur nicht spezifisch für die Lokalisierungsfunktionalität vorgesehen oder errichtet werden muss, wird durch die vorliegende Erfindung vorteilhaft eine Lokalisierung besonders aufwandsarm, kostengünstig und energieeffizient ermöglicht.

Da sich die feldverursachenden Infrastruktur typischerweise die innerhalb eines Gebäudes, beispielsweise des genannten Krankenhauses, eines Büro- oder Fabrikgebäudes oder dergleichen, befindet, wird die Feldverteilung direkt innerhalb dieses Gebäudes erzeugt und damit nicht durch das Gebäude abgeschirmt. Damit ermöglicht die vorliegende Erfindung vorteilhaft auch innerhalb von Gebäuden eine zuverlässige und energieeffiziente Lokalisierung, da beispielsweise keine von außerhalb des jeweiligen Gebäudes stammenden Signale empfangen oder gemessen werden müssen. Damit ist die vorliegende Erfindung also besondere für eine Indoor-Positionsbestimmung geeignet.

Besonders bevorzugt kann die jeweilige lokale Feldverteilung mehrfach hintereinander gemessen oder ein zeitlicher Verlauf der Feldverteilung gemessen werden. Dies kann es vorteilhaft ermöglichen, zeitlich variable Störeinflüsse, beispielsweise sich bewegende Feldquellen wie etwa mobile Geräte anderer in der Nähe befindlicher Personen, und deren Einfluss auf die gemessene Feldverteilung zu erkennen und zu eliminieren, also herauszurechnen. Dadurch kann eine verbesserte Genauigkeit und Zuverlässigkeit der Referenzfeldverteilung und letztlich bei dem Lokalisieren des Zusatzmoduls beziehungsweise des jeweiligen mit dem Zusatzmodul ausgestatteten Geräts erreicht werden.

Nachdem die jeweilige Position des Zusatzmoduls beziehungsweise des jeweiligen damit ausgestatteten Geräts bestimmt worden ist, kann diese durch das Zusatzmodul beziehungsweise das Gerät und/oder durch die Servereinrichtung bereitgestellt werden. Dadurch kann die jeweils aktuelle Position des Zusatzmoduls beziehungsweise des Geräts also jederzeit abgefragt oder abgerufen werden, wodurch sich abhängig von einem jeweiligen Einsatzgebiet vielfältige Vorteile ergeben können. So können beispielsweise Wartezeiten oder Verzögerungen vermieden werden, die bisher auftreten können, wenn etwa ein bestimmtes Bauteil oder Werkzeug oder Gerät für einen nächsten Arbeitsschritt benötigt wird, aber erst gesucht werden muss. Gerade im medizinischen Umfeld, insbesondere in Krankenhäusern können derartige Verzögerungen lebensbedrohliche Konsequenzen haben, die durch die vorliegende Erfindung vermieden oder reduziert werden können.

In vorteilhafter Ausgestaltung der vorliegenden Erfindung ist das erfindungsgemäße Zusatzmodul in Hardware ausgeführt und weist eine Anschlussschnittstelle auf, mittels derer das Zusatzmodul mit dem jeweiligen Gerät über eine korrespondierende geräteseitige Schnittstelle physisch verbindbar ist. Das Zusatzmodul kann dabei dazu eingerichtet sein, über die Anschlussschnittstelle elektrische Energie zu seinem Betrieb von dem jeweiligen Gerät zu beziehen, mit diesem zu kommunizieren und/oder auf Einrichtungen, Komponenten oder Ressourcen des jeweiligen Geräts zuzugreifen. So kann beispielsweise die Sensorik Teil des Zusatzmoduls oder Teil des jeweiligen Geräts sein und in letzterem Fall dann durch das Zusatzmodul angesteuert oder ausgelesen werden. Dadurch, dass das Zusatzmodul erfindungsgemäß über die Anschlussschnittstelle mit dem jeweiligen Gerät verbindbar ist, können sich also je nach Ausgestaltung der Anschlussschnittstelle beziehungsweise des jeweiligen Geräts eine Reihe unterschiedlicher Vorteile ergeben. Beispielsweise kann das Zusatzmodul gegebenenfalls besonders einfach und kompakt gebaut sein, da es nicht notwendigerweise eine eigene Energieversorgung aufweisen muss und/oder beispielsweise Rechenressourcen, die Sensorik und/oder eine Kommunikationseinrichtung des jeweiligen Geräts verwenden oder nutzen kann.

Da die Anschlussschnittstelle standardisiert sein kann, kann das Zusatzmodul dabei vorteilhaft besonders einfach massenhaft produziert und besonders einfach und flexibel für unterschiedliche Geräte verwendet werden. So ist beispielsweise eine besonders einfache Nachrüstung bestehender mobiler Geräte mit dem Zusatzmodul möglich. Die Anschlussschnittstelle kann beispielsweise als USB-, Thunderbolt- oder HDMI-Anschluss, als Teil einer RJ-Steckverbindung, als serielle Schnittstelle oder dergleichen ausgebildet sein.

Unbenommen ist dabei, dass das Zusatzmodul zusätzlich oder alternativ autark ausgebildet sein, also alle für die Lokalisierungsfunktionalität notwendigen Komponenten oder Einrichtungen selbst umfassen oder aufweisen kann. Das Zusatzmodul kann also beispielsweise eine eigene Energieversorgung, eine eigene Sensorik zum Messen der Feldverteilung, eine eigene Kommunikationseinrichtung zum Senden von Daten an die Servereinrichtung, ein eigenes Steuergerät mit einem Prozessor und einem Datenspeicher sowie einem Betriebsprogramm und/oder dergleichen aufweisen. Dies kann es vorteilhaft ermöglichen, das Zusatzmodul besonders flexibel auch dann einzusetzen, wenn das jeweilige mobile Gerät nicht über eine passende geräteseitige Schnittstelle verfügt. Dabei kann gegebenenfalls sogar auf die Anschlussschnittstelle des Zusatzmoduls verzichtet werden, wodurch dieses vorteilhaft besonders einfach beispielsweise wasser- und/oder staubdicht ausgebildet sein kann.

Besonders vorteilhaft kann das Zusatzmodul aber dazu eingerichtet sein, eine Verwendung von über die Anschlussschnittstelle verfügbaren oder erreichbaren Ressourcen des Geräts zu priorisierten gegenüber der Verwendung gegebenenfalls vorhandener eigener Einrichtungen oder Ressourcen des Zusatzmoduls, insbesondere dann, wenn die geräteseitigen, also über die Anschlussschnittstelle erreichbaren, Ressourcen leistungsstärker sind als die Ressourcen oder Einrichtungen des Zusatzmoduls.

In einer vorteilhaften alternativen Ausgestaltung der vorliegenden Erfindung ist das erfindungsgemäße Zusatzmodul in Software ausgeführt, also beispielsweise als Computerprogramm oder Computerprogrammprodukt implementiert. Die Messeinrichtung und die Lokalisierungseinrichtung sind dabei dann Funktionsblöcke der Software, also Softwaremodule, Softwarekomponenten, Subprogramme oder Subroutinen oder dergleichen. Das Zusatzmodul ist dann dazu eingerichtet, zum Messen der Feldverteilung sowie zum Bestimmen und Senden der Position beziehungsweise zum Senden der gemessenen Feldverteilung entsprechende Steueranweisungen an das jeweilige Gerät zu senden, die dies unter Verwendung der Einrichtungen oder Ressource des Geräts bewirken.

Mit anderen Worten kann das erfindungsgemäße Zusatzmodul hier also als zusätzliche Software auf einen Datenspeicher des jeweiligen Geräts aufgespielt werden, dass mit der Lokalisierungsfunktionalität in Form des Zusatzmoduls ausgestattet werden soll. Das Zusatzmodul nutzt dann vollständig vorhandene Hardware des jeweiligen Geräts. Die hier vorgeschlagene Lösung ermöglicht vorteilhaft einen besonders kostengünstigen und aufwandsarmen Einsatz des erfindungsgemäßen Zusatzmoduls, da beispielsweise automatisiert eine Vielzahl entsprechender Zusatzmodule auf eine Vielzahl Geräte gleichzeitig aufgespielt werden kann.

Zudem ermöglicht die Ausführung des erfindungsgemäßen Zusatzmoduls in Software eine besonders einfache und flexible Anpassbarkeit des Zusatzmoduls. Das Zusatzmodul kann also besonders einfach auch dann, wenn es bereits eingesetzt oder verwendet wird, aktualisiert und weiter verbessert werden. Ein weiterer Vorteil der Ausführung des Zusatzmoduls in Software liegt darin, dass gegebenenfalls ein bereits vorhandener Datenspeicher des jeweiligen Geräts zum Speichern des Zusatzmoduls verwendet werden kann, sodass in dem Gerät vorteilhaft kein zusätzlicher Bauraum für das Zusatzmodul benötigt wird.

Ebenso ist eine Kombination möglich, bei der das erfindungsgemäße Zusatzmodul teilweise in Hardware und teilweise in Software ausgeführt ist.

In weiterer vorteilhafter Ausgestaltung der vorliegenden Erfindung ist das Zusatzmodul dazu eingerichtet, zum Unterstützen der Lokalisierung automatisch ein Aussenden wenigstens eines Pings oder Ping-Signals durch das Zusatzmodul oder das jeweilige mobile Gerät in seine Umgebung zu veranlassen und Antwort-Signale oder Echos zu erfassen, die durch das Zusatzmodul oder das jeweilige Gerät von, insbesondere ortsfesten, Komponenten oder Geräten der felderzeugenden Infrastruktur empfangen werden. Weiterhin ist das Zusatzmodul dann dazu eingerichtet, automatisch anhand der Antwort-Signale und/oder deren Erfassungszeitpunkten eine Laufzeitanalyse durchzuführen und die Position des Zusatzmoduls auf Basis eines Ergebnisses der Laufzeitanalyse und der vorgegebenen Karte zu bestimmen. Zusätzlich oder alternativ ist das Zusatzmodul dazu eingerichtet, die Antwort-Signale, deren Erfassungszeitpunkte und/oder das Ergebnis der Laufzeitanalyse an die Servereinrichtung zu senden. Durch die Laufzeitanalyse, also ein Bestimmen einer Zeitdauer zwischen dem Aussenden des Ping-Signals und dem Empfangen der korrespondierenden Antwort-Signale kann auf einen Abstand des Zusatzmoduls beziehungsweise des jeweiligen mobilen Geräts zu den Komponenten oder Geräten der Infrastruktur, die die Antwortsignale senden oder gesendet haben, geschlossen werden. Zusätzlich oder alternativ können die Antwortsignale die jeweilige aussendende Komponente der Infrastruktur identifizieren.

Mit anderen Worten ist hier also zwar ein Signalaustausch zwischen dem Zusatzmodul beziehungsweise dem Gerät einerseits und der Infrastruktur andererseits vorgesehen, dieser Signalaustausch ist dabei aber minimal hinsichtlich einer Datenübertragung und seiner Anforderungen an die Infrastruktur, an verwendete Kommunikationsprotokolle oder -methoden und dergleichen mehr.

Das hier vorgesehene Ping-Verfahren ist grundsätzlich von einer Vielzahl von Geräten und darauf ausgeführter Software ausführbar, das Ping-Signal von diesen also ohne besondere Maßnahmen von diesen interpretierbar. Damit sind die Voraussetzungen für den Einsatz des erfindungsgemäßen Zusatzmoduls in der hier vorgeschlagenen Ausgestaltung weiterhin so begrenzt, dass es flexibel in einer Vielzahl unterschiedlicher Umgebungen, in der unterschiedliche Geräte, Software und Kommunikationsmethoden eingesetzt werden, angewendet werden kann, um das Lokalisieren zu unterstützen, also beispielsweise hinsichtlich seiner Genauigkeit oder Zuverlässigkeit zu verbessern. Es bietet sich hier vorteilhaft insbesondere eine zweite Methodik zur Lokalisierung, durch welche die Genauigkeit der Positionsbestimmung verbessert und/oder die auf der gemessenen Feldverteilung basierende Lokalisierung verifiziert oder plausibilisiert werden kann.

In weiterer vorteilhafter Ausgestaltung der vorliegenden Erfindung ist das Zusatzmodul dazu eingerichtet, zusätzlich ein Signal eines satellitengestützten Positionsbestimmungssystems (GPS, GlONASS, Galileo, etc.) zum Bestimmen der Position auszuwerten und/oder an die Servereinrichtung zu übermitteln. Mit anderen Worten kann das Zusatzmodul also einen Empfänger für Signale des satellitengestützten Positionsbestimmungssystems aufweisen oder Daten eines derartigen Empfängers des jeweiligen mobilen Geräts auslesen oder abfragen. Wie eingangs beschrieben kann die Genauigkeit einer Positionsbestimmung auf Basis eines satellitengestützten Positionsbestimmungssystems insbesondere innerhalb von Gebäuden reduziert sein. Die vorliegende Ausgestaltung der vorliegenden Erfindung beruht aber auf der Erkenntnis, dass durch das zusätzliche Heranziehen des Signals des satellitengestützten Positionsbestimmungssystems dennoch ein Vorteil gewonnen werden kann. So kann beispielsweise auf Basis des Satellitensignals, also beispielsweise eines GPS-, GLONASS- oder Galileo-Signals, oder einer Historie solcher Signale beispielsweise das jeweilige Gebäude oder ein jeweiliger Gebäudeflügel identifiziert werden, in dem sich das Zusatzmodul beziehungsweise das jeweilige Gerät derzeit befinden. Für eine genauere Lokalisierung kann dann wie beschrieben die gemessene lokale elektromagnetische Feldverteilung ausgewertet werden. Durch das Berücksichtigen des Satellitensignals kann dabei eine verbesserte Zuverlässigkeit oder eine Plausibilisierung der Positions- oder Ortsbestimmung erreicht werden, da beispielsweise bei gleichen lokalen Werten der Referenzfeldverteilung an unterschiedlichen Orten in unterschiedlichen Gebäudeflügeln oder unterschiedlichen Gebäuden die tatsächliche Position des Zusatzmoduls beziehungsweise des jeweiligen Geräts auf Basis des Satellitensignals eingegrenzt werden kann.

In weiterer vorteilhafter Ausgestaltung der vorliegenden Erfindung ist das Zusatzmodul dazu eingerichtet, anhand der gemessenen Feldverteilung und/oder anhand seiner bestimmten Position zu ermitteln, ob es sich in einem emissionssensiblen Bereich befindet und, sofern und solange dies der Fall ist, ein Senden von Signalen durch das Zusatzmodul und/oder das jeweilige mit dem Zusatzmodul ausgestattete Gerät zu verhindern oder zu verzögern. Beispielsweise kann das Senden der oben genannten Daten an die Servereinrichtung oder das beschriebene Aussenden des Ping-Signals solange zurückgestellt werden, bis anhand der gemessenen Feldverteilung und/oder anhand der bestimmten Position erkannt wird, dass ich das Zusatzmodul nicht länger in dem oder einem emissionssensiblen Bereich befindet.

Wie bereits beschrieben können derartige emissionssensible Bereiche beispielsweise eine Intensivstation oder eine Radiologie-Abteilung in einem Krankenhaus oder dergleichen sein. Auch in einem industriellen Umfeld oder beispielsweise im Bereich von Messeinrichtungen, Radioteleskopen und/oder dergleichen mehr kann das Verzögern oder Zurückstellen des Sendens von Signalen entsprechend vorteilhaft sein.

Entsprechende emissionssensible Bereiche können beispielsweise auf der vorgegebenen Karte oder in einer separaten Tabelle oder Datenbank vorgegeben oder hinterlegt sein. Zusätzlich oder alternativ kann ein emissionssensibler Bereich gegebenenfalls beispielsweise anhand der gemessenen Feldverteilung selbst durch das Zusatzmodul erkannt werden. Dazu können beispielsweise entsprechende vorgegebene Parameterwerte für die Feldverteilung hinterlegt sein, beispielsweise in einem Datenspeicher des Zusatzmoduls, die einen emissionssensible Bereich anzeigen oder entsprechend zu interpretieren sind. Ein Beispiel für einen solchen Parameterwert oder eine entsprechende Feldverteilung in einem emissionssensiblen Bereich kann beispielsweise ein Schwellenwert für eine Magnetfeldstärke sein. Eine oberhalb eines solchen vorgegebenen Schwellenwertes liegende Magnetfeldstärke kann beispielsweise in einer Umgebung eines Magnetresonanztomographen vorliegen.

Ein weiterer Aspekt der vorliegenden Erfindung ist eine Servereinrichtung mit einem Kommunikationsmodul und einem Datenspeicher sowie einem mit diesen, also mit dem Kommunikationsmodul und dem Datenspeicher, verbundenen Prozessor. Die erfindungsgemäße Servereinrichtung ist dabei dazu eingerichtet, mittels des Kommunikationsmoduls von, insbesondere mobilen, Geräten Messdaten zu empfangen, die jeweils eine lokal gemessene elektromagnetische Feldverteilung angeben, diese Messdaten automatisch mit einer in dem Datenspeicher hinterlegten vorgegebenen Karte abzugleichen und dadurch die jeweilige Position zu bestimmen, an der das jeweilige Gerät die jeweilige empfangene Feldverteilung gemessen hat. Die vorgegebene Karte gibt dabei wie bereits im Zusammenhang mit in dem erfindungsgemäßen Zusatzmoduls beschrieben eine ortsaufgelöste Referenzfeldverteilung und/oder Positionen einer feldverursachenden in, insbesondere ortsfesten, Infrastruktur an. Die Servereinrichtung ist weiterhin dazu eingerichtet, die bestimmte, dem jeweiligen Gerät zugeordnete Position in einer entsprechenden in dem Datenspeicher gespeicherten oder abgelegten Positionsdatenbank zu speichern oder zu aktualisieren. Die erfindungsgemäße Servereinrichtung kann also insbesondere die im Zusammenhang mit dem erfindungsgemäßen Zusatzmoduls genannte Servereinrichtung sein und dementsprechend die dort genannten oder beschriebenen Eigenschaften oder Merkmale aufweisen. Die erfindungsgemäße Servereinrichtung kann also beispielsweise ein Server, ein Cloudserver, ein Rechenzentrum oder dergleichen sein sowie gegebenenfalls weitere Komponenten oder Bauteile, beispielsweise weitere Schnittstellen, Datenleitungen, eine Energieversorgung und/oder dergleichen mehr aufweisen oder umfassen. Die erfindungsgemäße Servereinrichtung kann die Positionsdatenbank beispielsweise externen Geräten oder für entsprechenden Anfragen bereitstellen, sodass also die Positionen aller in der Positionsdatenbank eingetragenen Geräte durch die erfindungsgemäße Servereinrichtung bereitstellbar oder von der erfindungsgemäßen Servereinrichtung abfragbar ist.

Ein weiterer Aspekt der vorliegenden Erfindung ist ein System aus der erfindungsgemäßen Servereinrichtung und wenigstens einem erfindungsgemäßen Zusatzmodul, bevorzugt einer Vielzahl von erfindungsgemäßen Zusatzmodulen. Die Servereinrichtung und die Zusatzmodule können dabei bevorzugt softwareseitig aufeinander abgestimmt sein, also beispielsweise dazu eingerichtet sein, über ein vorgegebenes Kommunikationsprotokoll miteinander zu kommunizieren.

Ein weiterer Aspekt der vorliegenden Erfindung ist ein Verfahren zum Lokalisieren wenigstens eines Geräts, dass mit einem erfindungsgemäßen Zusatzmodul ausgestattet ist. Ein Verfahrensschritt des erfindungsgemäßen Verfahrens umfasst ein Kartieren einer elektromagnetischen Referenzfeldverteilung und/oder einer feldemittierenden oder felderzeugenden ortsfesten Infrastruktur in einem Überwachungsbereich, in dem das wenigstens eine mobile Gerät lokalisiert werden soll. Dazu können beispielsweise entsprechende Feldwerte der elektromagnetischen Feldverteilung für die Referenzfeldverteilung ortsaufgelöst gemessen werden, wobei also jeweilige Positionen, an denen die Feldwerte gemessen werden, erfasst und den dort gemessenen Feldwerten zugeordnet werden.

Ebenso kann beispielsweise anhand der Positionen der Infrastruktur eine rechnergestützte Simulation einer Feldausbreitung oder Feldverteilung durchgeführt werden, um die Referenzfeldverteilung als erwartete Feldverteilung in dem Überwachungsbereich zu bestimmen.

Ein weiterer Verfahrensschritt des erfindungsgemäßen Verfahrens umfasst ein Messen einer lokalen Feldverteilung mittels des zu lokalisierenden Geräts während oder wenn sich dieses in dem Überwachungsbereich befindet. Ein weiterer Verfahrensschritt des erfindungsgemäßen Verfahrens umfasst das automatische Lokalisieren des mobilen Geräts durch Abgleichen der gemessenen lokalen Feldverteilung mit der Karte, also der Referenzfeldverteilung und/oder den Positionen der Infrastruktur, durch das jeweilige mobile Gerät selbst und/oder durch die erfindungsgemäße Servereinrichtung, an die die gemessene Feldverteilung durch das Gerät gegebenenfalls übermittelt wurde.

Mit anderen Worten kann das erfindungsgemäße Verfahren also ein Verfahren zum Betreiben des erfindungsgemäßen Systems, der erfindungsgemäßen Servereinrichtung und/oder des erfindungsgemäßen Zusatzmoduls sein.

Das erfindungsgemäße Verfahren kann dementsprechend weitere Maßnahmen, Vorgänge oder Abläufe, die im Zusammenhang mit den übrigen Aspekten der vorliegenden Erfindung beschrieben sind, als - gegebenenfalls optionale - weitere Verfahrensschritte umfassen.

In vorteilhafter Ausgestaltung des erfindungsgemäßen Verfahrens wird zum Erzeugen der Karte der Referenzfeldverteilung diese mittels eines vorgegebenen Feldausbreitungsmodells simuliert. Dem Feldausbreitungsmodell werden dazu Positionen, Gerätetypen und Betriebsprofile von feldemittierenden Komponenten oder Geräten der ortsfesten Infrastruktur als Eingangsdaten bereitgestellt. Das Feldausbreitungsmodell kann also ein mathematisch-physikalisches Modell sein, dass eine Ausbreitung elektromagnetischer Wellen, Felder oder Strahlung in einem räumlichen Bereich und/oder eine zu erwartende resultierende Gesamtfeldverteilung - nämlich gerade die Referenzfeldverteilung - simuliert, die sich durch Zusammenwirken oder Überlagerung der Komponenten der Infrastruktur beziehungsweise der durch diese emittierten Einzelfelder ergibt oder einstellt. Insbesondere kann dem Feldausbreitungsmodell zudem eine Form oder Architektur des Überwachungsbereiches, beispielsweise in Form eines Gebäudeplans oder dergleichen, als Teil der Eingangsdaten bereitgestellt werden. Die Betriebsprofile der feldemittierenden Komponenten können beispielsweise deren Betriebszustand, Betriebszeiten oder eine, insbesondere zeitabhängige, Leistung, mit der die einzelnen Komponenten oder Geräte betrieben werden, angeben. Dies kann vorteilhaft zu einer besonders genauen und zuverlässigen Simulation der Referenzfeldverteilung beitragen.

Weiterer vorteilhafter Ausgestaltung der vorliegenden Erfindung wird für die Referenzfeldverteilung und die lokale Feldverteilung eine jeweilige Feldstärke frequenzaufgelöst für mehrere für unterschiedliche Kommunikationsmethoden vorgegebene Frequenzbereiche gemessen. Mit anderen Worten wird also beispielsweise gemessen, welche Einzelfeldstärken in unterschiedlichen Frequenzbereichen oder Frequenzbändern vorliegen und zu der jeweiligen Gesamtfeldverteilung beitragen. Es kann also beispielsweise gemessen werden, welche jeweiligen Feldstärken oder Feldverteilungskomponenten durch Mobilfunk, WLAN-Signale, eine niedrig-Energie-Kommunikation, Bluetooth, Infrarot, Radiokommunikation und/oder dergleichen mehr erzeugt werden. Dies kann vorteilhaft zu einer verbesserten Genauigkeit der Lokalisierung beitragen, da beispielsweise unterschiedliche Bereiche oder Positionen, in denen nominal oder integriert betrachtet die gleiche Feldstärke vorliegt, voneinander unterschieden werden könne anhand von Unterschieden in der jeweils vorliegenden Aufteilung oder Verteilung der Feldstärke beziehungsweise einer entsprechenden Feldenergie auf unterschiedliche Frequenzbereiche.

In weiterer vorteilhafter Ausgestaltung der vorliegenden Erfindung wird zum Erzeugen der Karte der Referenzfeldverteilung ein zeitlicher Verlauf der elektromagnetischen Feldverteilung in dem Überwachungsbereich über wenigstens einen vorgegebenen Zeitraum, bevorzugt über wenigstens einen Tag oder wenigstens eine Woche, hinweg gemessen. Dabei kann die Feldverteilung kontinuierlich gemessen werden oder es können während des vorgegebenen Zeitraums eine Vielzahl einzelner Messpunkte nacheinander aufgezeichnet werden. Der vorgegebene Zeitraum kann dabei abhängig sein von dem Überwachungsbereich oder einer in dem Überwachungsbereich regelmäßig stattfindenden Aktivität.

Folgt beispielsweise eine Aktivität oder ein Betrieb in dem Überwachungsbereich, insbesondere der Infrastruktur des Überwachungsbereiches, einem regelmäßigen oder periodischen Muster, so kann der vorgegebene Zeitraum bevorzugt wenigstens einer entsprechenden Periodendauer entsprechen. Beispielsweise gibt es in vielen Betrieben und Einrichtungen als derartige Periode einen Tag, da sich der Betrieb und damit gegebenenfalls auch die Feldverteilung über den Tag hinweg verändert, sich diese Veränderung aber zumindest im Wesentlichen jeden Tag wiederholt.

Durch das Messen des zeitlichen Verlaufes der Feldverteilung und das Erzeugen der Karte der Referenzfeldverteilung basierend auf diesem zeitlichen Verlauf können zeitliche, insbesondere periodische, Veränderungen der Feldverteilung in dem Überwachungsbereich erfasst und beim Lokalisieren des jeweiligen mobilen Geräts berücksichtigt werden. Insbesondere kann so eine verbesserte Genauigkeit und Zuverlässigkeit bei dem Lokalisieren erreicht werden.

In der Karte kann dabei der gesamte zeitliche Verlauf eingetragen sein. Ebenso können beispielsweise ausgewählte oder aus dem zeitlichen Verlauf berechnete Einzelwerte für unterschiedliche Zeiten oder Zeitintervalle des vorgegebenen Zeitraums in der Karte eingetragen sein. Beispielsweise können Maximal- und Minimalwerte, Durchschnittswerte für verschiedene Teile oder Intervalle des vorgegebenen Zeitraums und/oder dergleichen mehr in der Karte eingetragen sein. Dazu kann beispielsweise der vorgegebene Zeitraum in mehrere Intervalle vorgegebener zeitlicher Länge aufgeteilt werden, beispielsweise kann ein Tag in Arbeitszeit und nicht-Arbeitszeit oder beispielsweise in Intervalle von einer Stunde oder zwei Stunden oder drei Stunden Länge oder dergleichen oder ein vorgegebener Zeitraum von einer Woche in Intervalle von 12 Stunden oder 24 Stunden Länge aufgeteilt werden. Auf diese Weise kann vorteilhaft ein Datenvolumen der Karte reduziert, der zeitliche Verlauf der Feldverteilung aber dennoch berücksichtigt werden.

In vorteilhafter Weiterbildung der vorliegenden Erfindung wird der gemessene zeitliche Verlauf als Input, also als Eingangsdaten, an eine vorgegebene Maschinenlernkomponente, insbesondere ein deep-Learning-basiertes künstliches neuronales Netz, bereitgestellt. Diese Maschinenlernkomponente ist dabei darauf trainiert, die Referenzfeldverteilung durch Reduzieren von Rauschen in dem zeitlichen Verlauf, das durch nicht zu der ortsfesten Infrastruktur gehörende zeitlich variable Signal- oder Feldquellen verursacht wird, zu optimieren. Dadurch kann vorteilhaft die Genauigkeit und Zuverlässigkeit bei dem Lokalisieren des Geräts sowie gegebenenfalls eine Komplexität des Lokalisierens, beispielsweise des Abgleichens der gemessenen Feldverteilung mit der Referenzfeldverteilung, reduziert werden.

Als Trainingsdaten für die Maschinenlernkomponente können beispielsweise eine von externen Quellen unbeeinflusste Feldverteilung sowie verschiedene gemessene zeitliche Verläufe von Feldverteilungen, die unter Einfluss einer oder mehrerer, sich bevorzugt auf unterschiedliche Arten und Weisen durch den Überwachungsbereich bewegender, Quellen gemessen wurden, verwendet werden. Die trainierte Maschinenlernkomponente kann dann basierend auf dem jeweiligen Input eine bereinigte oder optimierte Referenzfeldverteilung als Output, also als Ausgabe- oder Ausgangsdaten, liefern.

Ein weiterer Aspekt der vorliegenden Erfindung ist ein Computerprogramm oder Computerprogrammprodukt, das Befehle umfasst, die bei einer Ausführung des Computerprogramms durch die erfindungsgemäße Servereinrichtung einerseits und das erfindungsgemäße Zusatzmodul oder das jeweilige damit ausgestattete Gerät andererseits eine Durchführung des erfindungsgemäßen Verfahrens bewirken. Mit anderen Worten kann das erfindungsgemäße Computerprogramm also durch das erfindungsgemäße System ausgeführt werden, um die Durchführung des erfindungsgemäßen Verfahrens zu bewirken und

Ein weiterer Aspekt der vorliegenden Erfindung ist ein computerlesbares Speichermedium, also ein computerlesbaren Datenträger, auf dem das erfindungsgemäße Computerprogramm oder Computerprogrammprodukt gespeichert ist.

Zum Ausführen des erfindungsgemäßen Computerprogramms, also eines entsprechenden Programmcodes, können das erfindungsgemäße System, die erfindungsgemäße Servereinrichtung und/oder das erfindungsgemäße Zusatzmodul jeweils einen entsprechenden Prozessor und ein jeweiliges entsprechendes computerlesbares Speichermedium, das mit dem jeweiligen Prozessor verbunden ist, aufweisen. Der Prozessor kann beispielsweise ein Mikrochip oder Mikroprozessor, eine integrierte Schaltung oder Hardwareschaltung oder Teil eines Controllers oder dergleichen sein.

Die bisher und im Folgenden angegebenen Eigenschaften und Weiterbildungen des erfindungsgemäßen Zusatzmoduls, der erfindungsgemäßen Servereinrichtung, des erfindungsgemäßen Verfahrens, des erfindungsgemäßen Computerprogramms und des erfindungsgemäßen computerlesbaren Speichermediums sowie die entsprechenden Vorteile sind jeweils sinngemäß wechselseitig zwischen diesen Aspekten der Erfindung übertragbar. Es gehören also zu der Erfindung auch solche jeweils Weiterbildungen der Aspekte der vorliegenden Erfindung, die Ausgestaltungen aufweisen, die hier zur Vermeidung unnötiger Redundanz nicht explizit in der jeweiligen Kombination oder nicht für jeden Aspekt der Erfindung separat beschrieben sind.

Weitere Merkmale, Einzelheiten und Vorteile der vorliegenden Erfindung ergeben sich aus der nachfolgenden Beschreibung bevorzugter Ausführungsbeispiele sowie anhand der Zeichnungen. Dabei zeigen:
- FIG 1: eine schematische Übersicht eines Systems aus einem mobilen Gerät und einem externen Server, wobei das mobile Gerät ein Zusatzmodul zur Lokalisierung aufweist;
- FIG 2: eine schematische Draufsicht auf einen Ausschnitt eines Innenbereich eines Gebäudes, in dem das Gerät aus FIG 1 mittels dessen Zusatzmoduls lokalisiert werden soll; und
- FIG 3: einen beispielhaften schematischen Ablaufplan für ein Verfahren zum Betreiben des Systems aus FIG 1 zum Lokalisieren des mobilen Geräts.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

In den Figuren sind gleiche, gleichartige, funktionsgleiche oder einander entsprechende Elemente jeweils mit den gleichen Bezugszeichen gekennzeichnet.

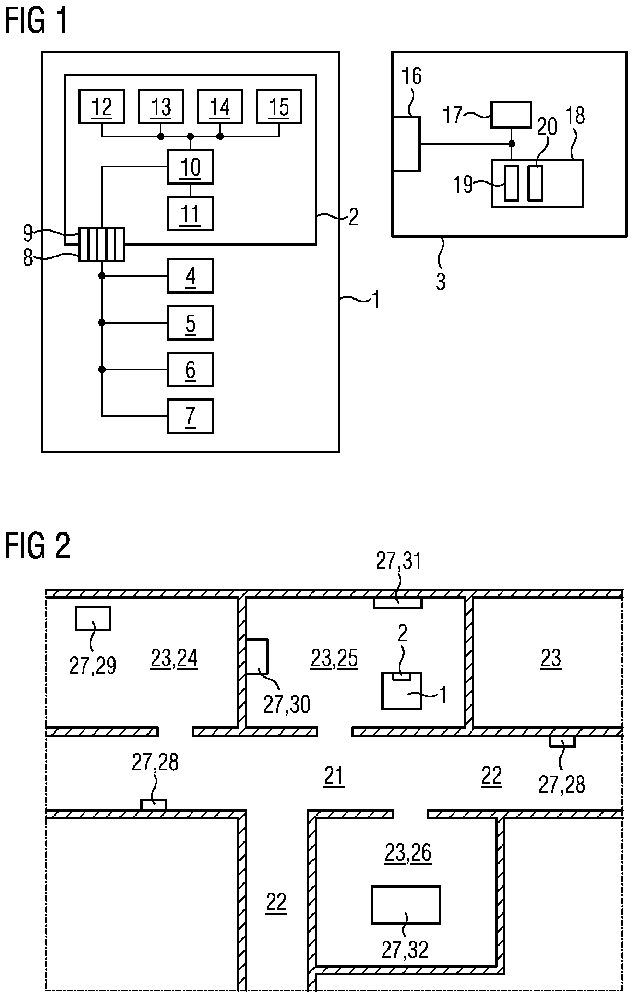

FIG 1 zeigt eine schematische Übersicht eines Systems aus einem mobilen Gerät 1, dass vorliegend mit einem Zusatzmodul 2 zum Bereitstellen einer Lokalisierungsfunktionalität für das mobile Gerät 1 ausgestattet ist, und einem externen Server 3.

Ein Lokalisieren oder orten und gegebenenfalls ein Nachverfolgen von Geräten, Gütern, Einrichtungen und/oder Personen, insbesondere wenn diese mobil sind und sich daher zu einem beliebigen Zeitpunkt an nicht a priori bekannten Positionen befinden können, erfordert bisher gerade in Innenräumen oder geschlossenen Umgebungen einen problematisch hohen Einsatz von Ressourcen und Zeit und kann beispielsweise eine dedizierte Infrastruktur aus aktiven Geräten voraussetzen, die nur mittels einer vorgegebenen Kommunikationsmethode und eines vorgegebenen Kommunikationsprotokolls kommunizieren.

Diesen Problemen und Herausforderungen soll vorliegend begegnet werden. Dazu weist das Gerät 1 vorliegend einen Geräteprozessor 4 und ein Speichermodul 5, also eine Datenverarbeitungseinrichtung, sowie ein Kommunikationsmodul 6 und ein GPS-Modul 7 auf. Diese Module beziehungsweise Einrichtungen sind untereinander und mit einer Modulschnittstelle 8 des Geräts 1 verbunden, an die vorliegend das Zusatzmodul 2 angeschlossen ist.

Das Zusatzmodul 2 weist dementsprechend seinerseits eine Anschlussschnittstelle 9 zum Verbinden des Zusatzmoduls 2 mit dem Gerät 1 auf. Darüber hinaus weist das Zusatzmodul 2 vorliegend einen Prozessor 10 und einen damit verbundenen Datenspeicher 11 auf. Ebenfalls mit dem Prozessor 10 verbunden sind weitere Einrichtungen des Zusatzmoduls 2, vorliegend umfassend eine Messeinrichtung 12, eine Lokalisierungseinrichtung 13, eine Kommunikationseinrichtung 14 und einem GPS-Empfänger 15.

Zumindest einige Module, Einrichtungen oder Komponenten sind hier also beispielhaft redundant sowohl in dem Gerät 1 als auch in dem Zusatzmodul 2 vorhanden. Dies stellt eine Realisierungsmöglichkeit dar, wobei aber zumindest einige Redundanzen für eine alternative, besonders kostensparende Ausgestaltung auf Seiten des Zusatzmoduls 2 und/oder auf Seiten des Geräts 1 eingespart werden können.

Bei dem Server 3 handelt es sich vorliegend um eine externe Einrichtung, sodass eine Kommunikation zwischen dem Gerät 1 beziehungsweise dem Zusatzmoduls 2 einerseits und dem Server 3 andererseits über eine kabellose Datenverbindung erfolgt. Dazu weist der Server 3 vorliegend eine Server-Kommunikationsschnittstelle 16 und damit verbunden einen Serverprozessor 17 und eine Speichereinrichtung 18 auf. In der Speichereinrichtung 18 sind vorliegend eine Gerätedatenbank 19 und eine Positionsdatenbank 20 gespeichert. In der Gerätedatenbank 19 sind eine Vielzahl von elektronischen Einrichtungen, wie beispielsweise das Gerät 1 und/oder das Zusatzmodul 2, registriert oder identifiziert. In der Positionsdatenbank 20 sind, sofern bekannt, bestimmte Positionen der in der Gerätedatenbank 19 identifizierten Einrichtungen oder Geräte gespeichert.

Mit dem in FIG 1 schematisch dargestellten System ist eine Lokalisierung des Geräts 1 auch in Innenräumen oder Gebäuden möglich. FIG 2 zeigt als eine derartige Umgebung beispielhaft eine schematische Draufsicht auf einen Ausschnitt eines Innenbereiches eines Gebäudes, in dem das Gerät 1 lokalisiert werden soll. Da also in dem dargestellten Innenbereich beziehungsweise Gebäude die Position des Geräts 1 bestimmt oder überwacht werden soll, wird der hier dargestellte Innenbereich auch als Überwachungsbereich 21 bezeichnet. Der Überwachungsbereich 21 umfasst vorliegend mehrere Korridore 22, von denen aus mehrere Räume 23 erreichbar sind. Vorliegend umfassen die Räume 23 beispielhaft unter anderem einen Geräteraum 24, einen Aufenthaltsraum 25 und einen Untersuchungsraum 26.

In dem Überwachungsbereich 21 verteilt angeordnet ist eine Infrastruktur 27 aus ortsfest installierten Geräten, die in dem Überwachungsbereich 21 eine elektromagnetische Feldverteilung erzeugen. Beispielhaft als Teil der Infrastruktur 27 dargestellt sind hier mehrere Zugangspunkte 28 (WLAN-Accesspoints), ein Drucker 29, ein Getränkeautomat 30, ein Fernsehgerät 31 und ein Magnetresonanztomograph, hier kurz bezeichnet als MRT 32.

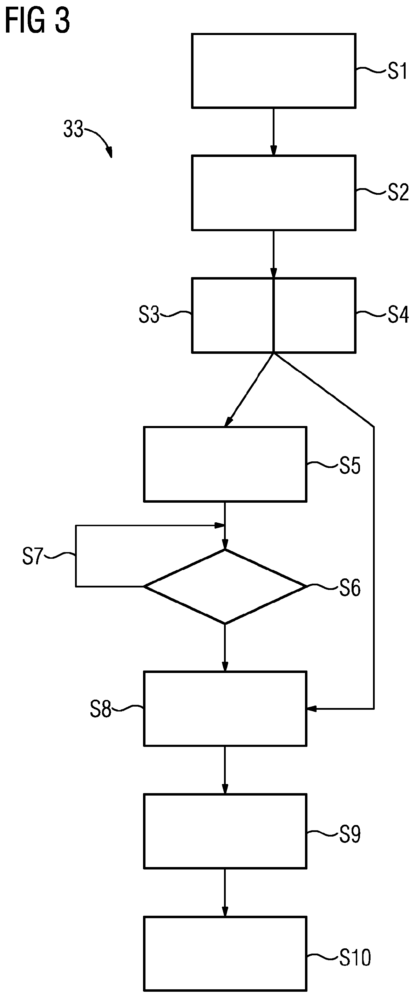

Ein Verfahren zum Lokalisieren des Geräts 1 in dem Überwachungsbereich 21 soll nachfolgend anhand eines in FIG 3 beispielhaft und schematisch dargestellten Ablaufplans 33 unter Bezugnahme auf FIG 1 und FIG 2 erläutert werden.

In einem Verfahrensschritt S1 wird zunächst eine Karte des Überwachungsbereiches 21 erstellt, die eine ortsaufgelöste elektromagnetische Referenzfeldverteilung in dem Überwachungsbereich 21 sowie die Positionen der Geräte oder Komponenten der feldverursachenden Infrastruktur 27 angibt. Dies kann ein Messen der Feldverteilung, eine entsprechende Simulation, eine KI- oder maschinenlerngestützte Optimierung und/oder dergleichen mehr umfassen. Die so erstellte Karte des Überwachungsbereiches 21 wird dann an den Server 3 und das Zusatzmodul 2 bereitgestellt.

In einem Verfahrensschritt S2 wird das Geräts 1 mit dem Zusatzmodul 2 ausgestattet. Hier wird also das Zusatzmodul 2 in das Gerät 1 integriert und an dessen Modulschnittstelle 8 angeschlossen.

Die Verfahrensschritt S1 und S2 können ebenso in einer anderen Reihenfolge oder parallel zueinander ausgeführt werden.

Nach Abschluss dieser vorbereitenden Schritte soll sich das mobile Gerät 1 im Einsatz befinden. Das mobile Gerät 1 kann beispielsweise ein Mobiltelefon, ein tragbarer Computer, ein mobiles medizinisches Gerät, eine Patientenliege, ein Werkzeug oder Instrument oder dergleichen sein. Vorliegend sei die Lokalisierungsfunktionalität des um das Zusatzmodul 2 erweiterten Geräts 1 aktiviert und das Gerät 1 befinde sich in dem Überwachungsbereich 21. In FIG 2 ist das Gerät 1 in einer beispielhaften Position in dem Aufenthaltsraum 25 dargestellt.

In einem Verfahrensschritt S3 wird am der Position des Geräts 1 die lokale elektromagnetische Feldverteilung gemessen. Dies kann vorliegend mittels der Messeinrichtung 12 des Zusatzmoduls 2 und/oder unter Verwendung einer entsprechenden Sensorik des Geräts 1 erfolgen, die dazu durch das Zusatzmodul 2, insbesondere durch die Messeinrichtung 12, angesteuert werden kann.

Parallel wird in einem Verfahrensschritt S4 durch das Gerät 1 beziehungsweise das Zusatzmodul 2, beispielsweise durch das Kommunikationsmodul 6 beziehungsweise die Kommunikationseinrichtung 14, ein Ping-Signal, also eine Echo-Anfrage, ausgesendet. Sofern daraufhin durch das Gerät 1 oder das Zusatzmodul 2 entsprechende Antwort-Signale einer oder mehrerer Geräte oder Komponenten der Infrastruktur 27 empfangen werden, wird eine darauf basierende Laufzeitanalyse durchgeführt, beispielsweise durch die Lokalisierungseinrichtung 13, etwa unter Verwendung des Prozessors 10 und/oder des Geräteprozessors 4.

In einem Verfahrensschritt S5 wird vorliegend anhand der gemessenen lokalen Feldverteilung und gegebenenfalls unter Berücksichtigung eines Ergebnisses der Laufzeitanalyse die Position des Geräts 1 bestimmt, beispielsweise durch die Lokalisierungseinrichtung 13. Dabei kann zudem ein Signal des GPS-Moduls 7 beziehungsweise des GPS-Empfängers 15 oder eine mittels dieser bestimmte Positions- oder Lokalisierungshistorie berücksichtigt werden, beispielsweise bis zu einem Zeitpunkt, zu dem das Gerät 1 in den Überwachungsbereich 21 gelangt ist. An der in FIG 2 beispielhaft dargestellten Position des Geräts 1 in dem Aufenthaltsraum 25 kann sich die dortige lokale elektromagnetische Feldverteilung beispielsweise zusammensetzen aus Signal- oder Feldanteilen, die von den Zugangspunkten 28, den Getränkeautomaten 30 und dem Fernsehgerät 31, nicht aber durch den Drucker 29 oder das MRT 32 erzeugt werden. Daraus ergibt sich an der Position des Geräts 1 eine individuelle positionsabhängige Überlagerung dieser Feldanteile zu der lokalen Feldverteilung, sodass durch einen Abgleich mit der vorgegebenen Karte die Position des Geräts 1 bestimmt werden kann.

In einem Verfahrensschritt S6 überprüft das Zusatzmodul 2 automatisch, ob die bestimmte Position innerhalb eines in der Karte als Signal- oder emissionssensibel gekennzeichneten Teilbereiches des Überwachungsbereiches 21 liegt. Vorliegend kann beispielsweise der Untersuchungsraum 26 mit dem MRT 32 als ein solcher sensibler Bereich gekennzeichnet sein. Ist dies der Fall, befindet sich also das Gerät 1 in einem sensiblen Bereich, so wird ein Aussenden von Signalen durch das Zusatzmodul 2 und das Gerät 1 automatisch verhindert oder verzögert bis sich das Gerät 1 nicht länger in einem sensiblen Bereich befindet. Dies ist hier vorliegend durch einen schleifenartigen Verfahrensschritt S7 angedeutet.

Sofern sich das Gerät 1 nicht oder nicht mehr in dem oder einem entsprechend sensiblen Bereich befindet, werden in einem Verfahrensschritt S8 ermittelte Daten an den Server 3 gesendet. Diese Daten können beispielsweise die gemessene Feldverteilung, die bestimmte Position, das Ergebnis der Laufzeitanalyse, Signale des GPS-Moduls 7 oder des GPS-Empfängers 15 und/oder dergleichen mehr umfassen. Gesendet werden können diese Daten beispielsweise mittels des Kommunikationsmoduls 6 oder der Kommunikationseinrichtung 14.

Wie hier durch einen alternativen Programmpfad angedeutet, können die Verfahrensschritte S5 bis S7 übersprungen, also auf eine Positionsbestimmung durch das Gerät 1 beziehungsweise des Zusatzmoduls 2 selbst verzichtet werden. Die im Verfahrensschritt S4 erfassten oder ermittelten Daten, also insbesondere die gemessene lokale Feldverteilung, können dann direkt im Verfahrensschritt S8 an den Server 3 übermittelt werden.

In einem Verfahrensschritt S9 verarbeitet der Server 3 die entsprechenden von dem Gerät 1 beziehungsweise dem Zusatzmodul 2 gesendeten und über die Server-Kommunikationsschnittstelle 16 empfangenen Daten mittels des Serverprozessors 17. Dies kann abhängig davon, welche Daten gesendet beziehungsweise empfangen wurden, unterschiedliche Vorgänge oder Berechnungsschritte umfassen. Beispielsweise kann der Server 3 seinerseits die Position des Geräts 1 anhand der empfangenen Daten bestimmen, das jeweilige Gerät 1 und/oder das jeweilige Zusatzmodul 2 identifizieren, überprüfen ob diese bereits in die Gerätedatenbank 19 eingetragen sind und/oder dergleichen mehr. Eine Bestimmung der Position des Geräts 1 durch den Server 3 kann dabei vorteilhaft sein, da der Server 3 typischerweise über mehr Berechnungskapazität oder -ressourcen verfügt als das Gerät 1 und das Zusatzmodul 2.

In einem Verfahrensschritt S10 aktualisiert der Server 3 die Positionsdatenbank 20 mit der bestimmten Position des Geräts 1 beziehungsweise des Zusatzmoduls 2. Da die Datenbank 20 anderen Nutzern, Geräten oder Programmen durch den Server 3 bereitgestellt wird, steht damit dann die aktuelle Position des Geräts 1 beziehungsweise des Zusatzmoduls 2 zur Verfügung, sodass diese durch Abfragen der Positionsdatenbank 20 aufgefunden werden können.

Vorliegend wird also ein durch die ohnehin in dem Überwachungsbereich 21 vorhandene felderzeugende Infrastruktur 27 gelieferter Umgebungskontext in Form der Feldverteilung ausgenutzt, um das Gerät 1 in einer jeweiligen Zielumgebung, hier also innerhalb des Überwachungsbereich 21, zu lokalisieren, also die Position des Geräts 1 zu bestimmen. Die Komponenten oder Geräte der Infrastruktur 27 können dabei in dem Überwachungsbereich 21 die elektromagnetische Feldverteilung erzeugen, indem sie aktiv Felder oder Signale aussenden und/oder allein aufgrund ihres regulären Betriebs. Die Komponenten der Infrastruktur 27 formen dabei anschaulich ein Netz, durch das die Feldverteilung in dem Überwachungsbereich 21 erzeugt oder aufgespannt wird. Durch Messen einer lokalen Ausprägung der Feldverteilung kann dann die jeweilige Position innerhalb dieses Netzes bestimmt werden.

Nicht nur das hier beispielhaft betrachtete mobile Gerät 1, sondern ebenso die Komponenten oder Geräte der Infrastruktur 27 können mit dem Zusatzmodul 2 ausgestattet sein oder ausgestattet werden. Damit können dann also die Positionen der Komponenten oder Geräte der Infrastruktur 27 ebenso bestimmt oder überwacht werden. Dies kann vorteilhaft beispielsweise ein Führen einer Inventarliste, ein Implementieren einer Diebstahlüberwachung, ein automatisches Anpassen der Referenzfeldverteilung bei Detektion einer Positionsveränderung einer Komponente der Infrastruktur 27, beispielsweise durch den Server 3, und dergleichen mehr ermöglichen.

Das Zusatzmodul 2 und dessen Funktionen können jeweils ganz oder teilweise in Hardware oder in Software ausgeführt sein. Dies kann abhängig sein von den Funktionen, die realisiert werden sollen, von der Art und Ausstattung des jeweiligen Geräts 1 beziehungsweise der jeweiligen Komponente der Infrastruktur 27 und/oder dergleichen mehr.

Insgesamt können in der beschriebenen Weise vorteilhaft eine vorhandene elektrische beziehungsweise elektronische Infrastruktur 27 für Lokalisierungszwecke genutzt und dabei bauteil- und kostensparend zumindest Teile der Lokalisierungsfunktionalität von der Infrastruktur 27 auf die zu lokalisierenden Geräte 1, Einrichtungen oder Elemente übertragen werden, sodass die Infrastruktur 27 nicht spezifisch für den Lokalisierungszweck ausgebildet sein oder angepasst werden muss. Damit zeigen die beschriebenen Beispiele, wie eine Lokalisierung von Geräten, Einrichtungen, Elementen oder Personen insbesondere in Gebäuden und sensiblen Bereichen besonders vorteilhaft ermöglicht werden kann.

## Patentansprüche

1. Zusatzmodul (2) zum Integrieren in ein bestehendes Gerät (1), um das Gerät (1) mit einer Lokalisierungsfunktionalität auszustatten, aufweisend eine Messeinrichtung (12) und eine Lokalisierungseinrichtung (13), wobei
- die Messeinrichtung (12) dazu eingerichtet ist, mittels einer Sensorik eine von einer jeweiligen umgebenden Infrastruktur (27), die sich innerhalb eines Gebäudes befindet, innerhalb des Gebäudes verursachte lokale elektromagnetische Feldverteilung passiv ohne Datenaustausch mit dieser Infrastruktur (27) zu messen, und
- die Lokalisierungseinrichtung (13) dazu eingerichtet ist, automatisch eine jeweils aktuelle räumliche Position des Zusatzmoduls (2) zu bestimmen durch Abgleichen der gemessenen Feldverteilung mit einer vorgegebenen Karte, die als Gebäudeplan des Gebäudes ausgestaltet ist und eine ortsaufgelöste Referenzfeldverteilung und Positionen der feldverursachenden Infrastruktur (27) angibt.

2. Zusatzmodul (2) nach Anspruch 1, wobei die Lokalisierungseinrichtung (13) dazu eingerichtet ist, zum Ermöglichen eines Nachverfolgens des Zusatzmoduls (2) die gemessene Feldverteilung und/oder die bestimmte Position über eine kabellose Datenverbindung an eine Servereinrichtung (3) zu senden.

3. Zusatzmodul (2) nach einem der Ansprüche 1 oder 2, **dadurch gekennzeichnet, dass** das Zusatzmodul (2) in Hardware ausgeführt ist und eine Anschlussschnittstelle (9) aufweist, mittels derer das Zusatzmodul (2) mit dem jeweiligen Gerät (1) über eine korrespondierende geräteseitige Schnittstelle (8) physisch verbindbar ist.

4. Zusatzmodul (2) nach einem der Ansprüche 1 oder 2, **dadurch gekennzeichnet, dass** das Zusatzmodul (2) in Software ausgeführt ist, wobei die Messeinrichtung (12) und die Lokalisierungseinrichtung (13) Funktionsblöcke der Software sind und das Zusatzmodul (2) dazu eingerichtet ist, zum Messen der Feldverteilung sowie zum Bestimmen und Senden der Position beziehungsweise zum Senden der gemessenen Feldverteilung entsprechende Steueranweisungen an das jeweilige Gerät (1) zu senden.

5. Zusatzmodul (2) nach einem der vorhergehenden Ansprüche, **dadurch gekennzeichnet, dass** das Zusatzmodul (2) dazu eingerichtet ist, zum Unterstützen der Lokalisierung automatisch ein Aussenden wenigstens eines Ping-Signals in seine Umgebung durch das Zusatzmodul (2) oder das jeweilige Gerät (1) zu veranlassen und Antwort-Signale zu erfassen, die durch das Zusatzmodul (2) oder das jeweilige Gerät (1) von Komponenten (28, 29, 30, 31, 32) der feldverursachenden Infrastruktur (27) empfangen werden, und automatisch
- anhand der Antwort-Signale und/oder deren Erfassungszeitpunkten eine Laufzeitanalyse durchzuführen und die Position des Zusatzmoduls (2) auf Basis eines Ergebnisses der Laufzeitanalyse und der vorgegeben Karte zu bestimmen, und/oder
- die Antwort-Signale, deren Erfassungszeitpunkte und/oder das Ergebnis der Laufzeitanalyse an die Servereinrichtung (3) zu senden.

6. Zusatzmodul (2) nach einem der vorhergehenden Ansprüche, **dadurch gekennzeichnet, dass** das Zusatzmodul (2) dazu eingerichtet ist, zusätzlich ein Signal eines satellitengestützten Positionsbestimmungssystems auszuwerten, um die Position zu Bestimmen, und/oder an die Servereinrichtung (3) zu übermitteln.

7. Zusatzmodul (2) nach einem der vorhergehenden Ansprüche, **dadurch gekennzeichnet, dass** das Zusatzmodul (2) dazu eingerichtet ist, anhand der gemessenen Feldverteilung und/oder anhand seiner bestimmten Position zu ermitteln, ob es sich in einem emissionssensiblen Bereich (26) befindet und, sofern und solange dies der Fall ist, ein Senden von Signalen durch das Zusatzmodul (2) und/oder das jeweilige mit dem Zusatzmodul (2) ausgestattete Gerät (1) zu verzögern.

8. Verfahren (33) zum Lokalisieren wenigstens eines Geräts (1), das mit einem Zusatzmodul (2) nach einem der Ansprüche 1 bis 7 ausgestattet ist, umfassend die Verfahrensschritte
- Kartieren einer elektromagnetischen Referenzfeldverteilung innerhalb eines Gebäudes und einer feldemittierenden ortsfesten Infrastruktur, die sich innerhalb des Gebäudes befindet, (27) in einem Überwachungsbereich (21), in dem das Gerät (1) lokalisiert werden soll,
- Messen einer lokalen Feldverteilung innerhalb des Gebäudes mittels des zu lokalisierenden Geräts (1) wenn sich dieses in dem Überwachungsbereich (21) befindet, und
- automatisches Lokalisieren des Geräts (1) durch Abgleichen der gemessenen lokalen Feldverteilung mit der Karte durch das Gerät (1).

9. Verfahren (33) nach Anspruch 8, außerdem umfassend automatisches Lokalisieren des Geräts (1) durch Abgleichen der gemessenen lokalen Feldverteilung mit der Karte durch eine Servereinrichtung (3), an die die gemessene Feldverteilung durch das Gerät (1) übermittelt wurde, wobei die Servereinrichtung (3) ein Kommunikationsmodul (16) und einen Datenspeicher (18) sowie einen mit diesen verbundenen Prozessor (17) aufweist, wobei mittels des Kommunikationsmoduls (16) von dem Gerät (1) Messdaten empfangen werden, die die am Ort des Geräts lokal gemessene elektromagnetische Feldverteilung angeben, diese Messdaten mittels der Servereinrichtung (3) automatisch mit der Karte abgeglichen werden und dadurch die Position bestimmt wird, an der das Gerät (1) die empfangene Feldverteilung gemessen hat, und die bestimmte, dem Gerät (1) zugeordnete Position in einer in dem Datenspeicher (18) gespeicherten Positionsdatenbank (20) gespeichert oder aktualisiert wird.

10. Verfahren (33) nach einem der Ansprüche 8 oder 9, **dadurch gekennzeichnet, dass** zum Erzeugen der Karte der Referenzfeldverteilung diese mittels eines vorgegebenen Feldausbreitungsmodells simuliert wird, wobei dem Feldausbreitungsmodell Positionen, Gerätetypen und Betriebsprofile von feldemittierenden Komponenten der ortsfesten Infrastruktur (27) als Eingangsdaten bereitgestellt werden.

11. Verfahren (33) nach einem der Ansprüche 8 bis 10, **dadurch gekennzeichnet, dass** für die Referenzfeldverteilung und die lokale Feldverteilung eine jeweilige Feldstärke frequenzaufgelöst für mehrere für unterschiedliche Kommunikationsmethoden vorgegebene Frequenzbereiche gemessen wird.

12. Verfahren (33) nach einem der Ansprüche 8 bis 11, **dadurch gekennzeichnet, dass** zum Erzeugen der Karte der Referenzfeldverteilung ein zeitlicher Verlauf der elektromagnetischen Feldverteilung in dem Überwachungsbereich über wenigstens einen vorgegebenen Zeitraum, bevorzugt über wenigstens einen Tag oder wenigstens eine Woche, hinweg gemessen wird.

13. Verfahren (33) nach Anspruch 12, **dadurch gekennzeichnet, dass** der gemessene zeitliche Verlauf als Input an eine vorgegebene Maschinenlernkomponente, insbesondere ein Deep-Learning-basiertes künstliches neuronales Netz, bereitgestellt wird, die darauf trainiert ist, die Referenzfeldverteilung durch Reduzieren von Rauschen, das durch nicht zu der ortsfesten Infrastruktur (27) gehörende zeitlich variable Quellen verursacht wird, in dem zeitlichen Verlauf zu optimieren.

## Claims

1. Add-on module (2) for integration in an existing device (1) in order to equip the device (1) with a localisation functionality, comprising a measuring unit (12) and a localisation unit (13), wherein
- the measuring unit (12) is configured to measure passively by means of sensors a local electromagnetic field distribution generated by a given surrounding infrastructure (27), which is located inside a building, inside the building, without any data being exchanged with this infrastructure (27), and
- the localisation unit (13) is configured, automatically to determine an instantaneous spatial position of the add-on (2) module by comparing the measured field distribution with a specified map that is in the form of a building plan of the building and defines a spatially resolved reference field distribution and positions of the field-generating infrastructure (27).

2. Add-on module (2) according to claim 1, wherein the localisation unit (13) is configured, in order to facilitate tracking of the add-on module (2), to send the measured field distribution and/or the determined position via a wireless data connection to a server unit (3).

3. Add-on module (2) according to one of claims 1 or 2, **characterised in that** the add-on module (2) is implemented in hardware and comprises a connection interface (9), by means of which the add-on module (2) can be connected physically to the associated device (1) via a corresponding device-based interface (8).

4. Add-on module (2) according to one of claims 1 or 2, **characterised in that** the add-on module (2) is implemented in software, wherein the measuring unit (12) and the localisation unit (13) are function blocks of the software, and the add-on module (2) is configured to send to the associated device (1) appropriate control instructions for measuring the field distribution and for determining and sending the position, or for sending the measured field distribution.

5. Add-on module (2) according to one of the preceding claims, **characterised in that** the add-on module (2) is configured, in order to assist the localisation, automatically to cause the add-on module (2) or the associated device (1) to emit at least one ping signal into its surrounding area and to detect response signals, which are received by the add-on module (2) or the associated device (1) from components (28, 29, 30, 31, 32) of the field-generating infrastructure (27), and automatically
- to perform a transit-time analysis based on the response signals and/or the times at which they were detected, and to determine the position of the add-on module (2) on the basis of a result of the transit-time analysis and the specified map, and/or
- to send to the server unit (3) the response signals, the times at which they were detected, and/or the result of the transit-time analysis.

6. Add-on module (2) according to one of the preceding claims, **characterised in that** the add-on module (2) is configured additionally to analyse a signal from a satellite-based positioning system, in order to determine the position, and/or to transfer said signal to the server unit (3).

7. Add-on module (2) according to one of the preceding claims, **characterised in that** the add-on module (2) is configured to ascertain from the measured field distribution and/or from its own determined position, whether it is in an emission-sensitive zone (26), and if, and as long as, this is the case, to delay any sending of signals by the add-on module (2) and/or the associated device (1) equipped with the add-on module (2).

8. Method (33) for localising at least one device (1), which is equipped with an add-on module (2) according to one of claims 1 to 7, comprising the method steps:
- mapping an electromagnetic reference field distribution inside a building and a field-emitting stationary infrastructure, which is located inside the building, (27) in a monitoring region (21) in which the device (1) is meant to be localised;
- measuring a local field distribution inside the building by means of the device (1) to be localised if this device is in the monitoring region (21); and
- automatically localising the device (1) by comparing the measured local field distribution with the map by means of the device (1).

9. Method (33) according to claim 8, also comprising automatically localising the device (1) by comparing the measured local field distribution with the map, by way of a server unit (3), to which the measured field distribution has been transferred by the device (1), wherein the server unit (3) has a communication module (16) and a data storage medium (18) and also a processor (17) connected to each, wherein measurement data that indicates the electromagnetic field distribution measured locally at the location of the device is received by the device (1) by means of the communication module (16), this measurement data is automatically compared with the map by means of the server unit (3) and thereby the position is determined at which the device (1) has measured the received field distribution, and the determined position associated with the device (1) is stored or updated in a position database (20), which is stored in the data storage medium (18).

10. Method (33) according to one of claims 8 or 9, **characterised in that** in order to produce the map of the reference field distribution, a specified field propagation model is used to simulate this map, wherein the field propagation model is provided with positions, device types and operating profiles of field-emitting components of the stationary infrastructure (27) as input data.

11. Method (33) according to one of claims 8 to 10, **characterised in that** for the reference field distribution and the local field distribution, a field strength is measured in a frequency-resolved manner for each of a plurality of frequency ranges specified for different communication methods.

12. Method (33) according to one of claims 8 to 11, **characterised in that** in order to produce the map of the reference field distribution, a variation in the electromagnetic field distribution over time in the monitoring region is measured over at least a specified time period, preferably over at least one day or at least one week.

13. Method (33) according to claim 12, **characterised in that** the measured variation over time is provided as an input to a specified machine learning component, in particular to a deep-learning based artificial neural network, which is trained to optimise the reference field distribution by reducing noise in the variation over time, which noise is caused by time-varying sources that do not belong to the stationary infrastructure (27).

## Revendications

1. Module (2) supplémentaire à intégrer dans un appareil (1) existant, afin d'équiper l'appareil (1) d'une fonctionnalité de localisation, comportant un dispositif (12) de mesure et un dispositif (13) de localisation, dans lequel
- le dispositif (12) de mesure est agencé pour mesurer, de manière passive sans échange de données avec une infrastructure (27), une répartition locale du champ électromagnétique provoqué à l'intérieur d'un bâtiment par l'infrastructure (27) respective, qui l'entoure et qui se trouve à l'intérieur du bâtiment, et
- le dispositif (13) de localisation est agencé pour déterminer automatiquement une position en cours respective dans l'espace du module (2) supplémentaire en ajustant la répartition du champ mesuré avec une carte donnée à l'avance, qui est conformée sous la forme d'un plan du bâtiment et qui indique une répartition du champ de référence à résolution spatiale et des positions de l'infrastructure (27) provoquant le champ.

2. Module (2) supplémentaire suivant la revendication 1, dans lequel le dispositif (13) de localisation est agencé, pour permettre un suivi du module (2) supplémentaire, pour envoyer la répartition du champ mesuré et/ou la position déterminée à un dispositif (3) serveur par une liaison de données sans câble.

3. Module (2) supplémentaire suivant l'une des revendications 1 ou 2, **caractérisé en ce que** le module (2) supplémentaire est réalisé en matériel et a une interface (9) de connexion, au moyen de laquelle le module (2) supplémentaire peut être relié physiquement à l'appareil (1) respectif en passant par une interface (8) correspondante du côté de l'appareil.

4. Module (2) supplémentaire suivant l'une des revendications 1 ou 2, **caractérisé en ce que** le module (2) supplémentaire est réalisé en logiciel, dans lequel le dispositif (12) de mesure et le dispositif (13) de localisation sont des blocs fonctionnels du logiciel et le module (2) supplémentaire est agencé pour envoyer à l'appareil (1) respectif, pour la mesure de la répartition du champ, ainsi que la détermination et l'envoi de la position ou respectivement l'envoi de la répartition du champ mesuré, des instructions de commande correspondantes.

5. Module (2) supplémentaire suivant l'une des revendications précédentes, **caractérisé en ce que** le module (2) supplémentaire est agencé pour, pour venir à l'appui de la localisation, provoquer automatiquement un envoi d'au moins un signal ping à son environnement par le module (2) supplémentaire ou par l'appareil (1) respectif et détecter des signaux de réponse, qui sont reçus par le module (2) supplémentaire ou par l'appareil (1) respectif de composants (28, 29, 30, 31, 32) de l'infrastructure (27) provoquant le champ et, pour automatiquement,
- à l'aide des signaux de réponse et/ou de leurs instants de détection, effectuer une analyse du temps de parcours et déterminer la position du module (2) supplémentaire sur la base d'un résultat de l'analyse du temps de parcours et de la carte donnée à l'avance, et/ou
- envoyer au dispositif (3) serveur les signaux de réponse, leurs instants de détection et/ou le résultat de l'analyse du temps de parcours.

6. Module (2) supplémentaire suivant l'une des revendications précédentes, **caractérisé en ce que** le module (2) supplémentaire est agencé pour évaluer supplémentairement un signal d'un système de détermination de position assisté par satellite, afin de déterminer la position et/ou de la transmettre au dispositif (3) serveur.

7. Module (2) supplémentaire suivant l'une des revendications précédentes, **caractérisé en ce que** le module (2) supplémentaire est agencé pour, à l'aide de la répartition du champ mesuré et/ou à l'aide de sa position déterminée, déterminer s'il se trouve dans une zone (26) sensible à l'émission et pour, dans la mesure où et tant que cela est le cas, retarder l'envoi de signaux par le module (2) supplémentaire et/ou l'appareil (1) respectif équipé du module (2) supplémentaire.

8. Procédé (33) de localisation d'au moins un appareil (1), qui est équipé d'un module (2) supplémentaire suivant l'une des revendications 1 à 7, comprenant les stades de procédé
- cartographier une répartition de champ de référence électromagnétique dans un bâtiment et une infrastructure (27) d'émission du champ, qui se trouve à l'intérieur du bâtiment, dans une zone (21) de contrôle, dans laquelle l'appareil (1) doit être localisé,
- mesurer une répartition du champ local dans le bâtiment au moyen de l'appareil (1) à localiser, si celui-ci se trouve dans la zone (21) de contrôle, et
- localiser automatiquement l'appareil (1) en ajustant la répartition du champ local mesuré avec la carte par l'appareil (1).

9. Procédé (33) suivant la revendication 8, comprenant en outre localiser automatiquement l'appareil (1) par ajustement de la répartition du champ local mesuré avec la carte par un dispositif (3) serveur, auquel la répartition du champ mesuré a été transmise par l'appareil (1), dans lequel le dispositif (3) serveur a un module (16) de communication et une mémoire (18) de données, ainsi qu'un processeur (17) relié à ceux-ci, dans lequel, au moyen du module (16) de communication, sont reçues par l'appareil (1) des données de mesure, qui indiquent la répartition du champ électromagnétique mesuré localement à l'emplacement de l'appareil, ces mesures sont, au moyen du dispositif (3) serveur, ajustées automatiquement avec la carte et il est ainsi déterminé la position à laquelle l'appareil (1) a mesuré la répartition du champ reçu, et la position déterminée associée à l'appareil (1) est mise en mémoire ou mise à jour dans une base (20) de données de position mise dans la mémoire (18) de données.

10. Procédé (33) suivant l'une des revendications 8 ou 9, **caractérisé en ce que**, pour la production de la carte de la répartition du champ de référence, on simule celle-ci au moyen d'un modèle donné à l'avance de propagation du champ, dans lequel on met à disposition du modèle de propagation du champ, comme données d'entrée, des positions, des types d'appareil et des profils de fonctionnement de composants d'émission du champ de l'infrastructure (27) fixe en position.

11. Procédé (33) suivant l'une des revendications 8 à 10, **caractérisé en ce que**, pour la répartition du champ de référence et la répartition du champ local, on mesure une intensité respective du champ d'une manière résolue en fréquence pour plusieurs domaines de fréquence donnés à l'avance par des méthodes de communication différentes.

12. Procédé (33) suivant l'une des revendications 8 à 11, **caractérisé en ce que**, pour la production de la carte de la répartition du champ de référence, on mesure une courbe en fonction du temps de la répartition du champ électromagnétique dans la zone de contrôle pendant au moins un laps de temps donné à l'avance, de préférence pendant au moins jour ou au moins une semaine.

13. Procédé (33) suivant la revendication 12, **caractérisé en ce que** l'on met la courbe en fonction du temps mesurée comme entrée à disposition d'un composant d'apprentissage automatique donné à l'avance, en particulier d'un réseau neuronal artificiel reposant sur l'apprentissage profond, qui est entraîné pour optimiser, dans la courbe en fonction du temps, la répartition du champ de référence par réduction du bruit, qui est provoqué par des sources variables en fonction du temps n'appartenant pas à l'infrastructure (27) fixe en emplacement.
